# EUROPÄISCHE PATENTSCHRIFT

(11) **EP 3 454 312 B1**
(45) Veröffentlichungstag und Bekanntmachung des Hinweises auf die Patenterteilung: **07.08.2019**
(21) Anmeldenummer: 17190310.7
(22) Anmeldetag: 11.09.2017
(51) Int. Cl.: G08B 17/107

(54) **OPTISCHER RAUCHMELDER MIT EINEM AUFSCHWENKBAREN LEITERPLATTENABSCHNITT MIT EINEM DARAUF ANGEORDNETEN LICHTSENDER UND/ODER LICHTEMPFÄNGER**
OPTICAL SMOKE ALARM WITH A PIVOTABLE CONDUCTOR PLATE SECTION WITH A LIGHT TRANSMITTER AND/OR RECEIVER ARRANGED ON SAME
DÉTECTEUR DE FUMÉE OPTIQUE DOTÉ D'UNE SECTION DE CARTE DE CIRCUITS IMPRIMÉS POUVANT PIVOTER POURVUE D'UN ÉMETTEUR DE LUMIÈRE ET/OU D'UN RÉCEPTEUR DE LUMIÈRE DISPOSÉS SUR LADITE SECTION

(43) Veröffentlichungstag der Anmeldung: 13.03.2019
(73) Patentinhaber: Siemens Schweiz AG, 8047 Zürich (CH)
(72) Erfinder: Ebner, Harald, 6340 Baar (CH); Konrad, Hilmar, 6340 Baar (CH)
(74) Vertreter: Maier, Daniel Oliver

(56) Entgegenhaltungen:
- WO-A1-2009/150133
- WO-A1-2012/127355
- WO-A2-2013/027169
- GB-A- 2 527 117

## Beschreibung

### BESCHREIBUNGSEINLEITUNG

Die Erfindung betrifft einen optischen Rauchmelder, welcher eine Leiterplatte mit einer einheitlichen Leiterplattendicke sowie einen Lichtsender und einen Lichtempfänger aufweist. Der Lichtsender ist insbesondere eine Leuchtdiode, wie z.B. eine Infrarot-LED oder eine blauleuchtende LED, und vorzugsweise als SMD-Leuchtdiode (SMD für "Surface-Mounted Device") für eine Oberflächenmontage auf der Leiterplatte ausgebildet. Der Lichtempfänger ist insbesondere eine Photodiode und vorzugsweise auch als SMD-Bauteil ausgebildet. Der Lichtsender und der Lichtempfänger sind jeweils auf einem Abschnitt der Leiterplatte angeordnet. Der jeweilige Leiterplattenabschnitt ist aus einer ebenen Position in einer gemeinsamen Ebene mit der Leiterplatte in eine für die optische Rauchdetektion vorgesehene Schwenkposition schwenkbar und dort fixierbar.

### STAND DER TECHNIK

Aus der DE 10 2012 209 100 A1 ist ein optischer Brandmelder mit einem Lichtemitter, mit einem das Streulicht des Lichtemitters empfangenden Lichtempfänger und mit einer Leiterplatte bekannt, wobei der Lichtemitter und der Lichtempfänger jeweils auf einem Leiterplattenabschnitt der Leiterplatte angeordnet sind. Es ist mindestens einer der zwei Leiterplattenabschnitte in einer gewinkelten Position gewinkelt zu einer Flächenerstreckung der Leiterplatte angeordnet. Zum möglichen Aufschwenken weist der jeweilige Leiterplattenabschnitt einen geschwächten, dünner ausgebildeten Leiterplattenbereich auf. Die optoelektronischen Bauelemente des Brandmelders sind als SMD-Bauelemente ausgeführt.

Nachteilig dabei ist, dass der z.B. mittels eines abtragenden Verfahrens geschwächte, verjüngte Leiterplattenabschnitt mechanisch empfindlich und nicht sehr robust ist. Er kann somit leicht vom Rest der Leiterplatte abbrechen, wie z.B. bei einer Stoßbelastung oder beim Herunterfallen. Zudem ist der herstellungstechnische Aufwand für die Schwächung des Basismaterials auf Maß (z.B. Fräsen) nicht unerheblich, da der zu verjüngenden Bereich in jede einzelne Leiterplatte durch Abtragung eingebracht werden muss.

Aus der DE 100 54 110 A1 ist ein fotoelektrischer Rauchdetektor bekannt, bei dem sowohl ein lichtemittierendes, als auch ein lichtempfangenes Element jeweils auf einer separaten Leiterplatte angeordnet sind. Beide Leiterplatten sind orthogonal zu einer Hauptplatine des Rauchdetektors angeordnet. Das lichtemittierende und lichtempfangene Element sind in einer Streulichtanordnung zueinander angeordnet (siehe FIG. 20).

Optische Rauchmelder weisen eine in einem Meldergehäuse aufgenommene Leiterplatte auf. Eine Leiterplatte ist ein Verbundwerkstoff umfassend ein elektrisch nichtleitendes Trägermaterial, wie z.B. ein Glasfasergewebe mit Epoxidharz, und eine leitfähige Struktur, typischerweise Kupfer auf dem Glasfasergewebe. Die Leiterplatte umfasst für die Herstellung mindestens eine Lage eines Basismaterials, das als elektrisch nichtleitendes Trägermaterial verwendet wird, sowie mindestens eine leitfähige Struktur auf ein oder mehreren Seiten des Trägermaterials. Ein bekanntes Basismaterial ist das sogenannte FR4-Basismaterial aus Glasfasergewebe mit Epoxidharz und das FR2-Basismaterial aus Hartpapier. FR-4 oder auch FR4 bezeichnet eine Klasse von schwer entflammbaren und flammenhemmenden Verbundwerkstoffen bestehend aus Epoxidharz und Glasfasergewebe. Die Abkürzung FR steht für "flame retardant", also für flammhemmend. Der Verbundwerkstoff FR-4 wurde 1968, neben anderen Verbundwerkstoffen, von der National Electrical Manufacturers Association (NEMA) in den Eigenschaften in der Spezifikation NEMA LI1 festgelegt.

Ausgehend vom eingangs genannten Stand der Technik ist es eine Aufgabe der Erfindung, einen optischen Rauchmelder anzugeben, der fertigungstechnisch weniger aufwändig hergestellt werden kann.

Es ist eine weitere Aufgabe der Erfindung, einen optischen Rauchmelder anzugeben, der vollautomatisch herstellbar ist.

### LÖSUNG DER AUFGABE

Die Aufgabe der Erfindung wird durch die Merkmale des Hauptanspruchs 1 gelöst. Vorteile und Ausgestaltungen der Erfindung, die einzeln oder in Kombination miteinander einsetzbar sind, sind Gegenstand der abhängigen Ansprüche.

### BESCHREIBUNG DER ERFINDUNG

Erfindungsgemäß weist die für die Rauchdetektion vorgesehene Schwenkposition einen Winkel in einem Bereich von 30° bis 90° auf. Es ist zumindest einer der beiden Leiterplattenabschnitte jeweils bis auf zumindest einen verbleibenden Steg durch zumindest eine durchgehende Ausnehmung in der Leiterplatte ausgeformt. Zudem weist der jeweilige Steg eine derart bemessene (Mindest-)Steglänge auf, dass ein in der Schwenkposition in den jeweiligen Steg eingebrachtes Biege- und/oder Torsionsmoment den jeweiligen Steg biegeelastisch, insbesondere reversibel biegeelastisch, verformt.

Mit anderen Worten wird der jeweilige Steg nicht plastisch verformt, und es treten keine signifikanten strukturellen Schäden an dem Basismaterial der Leiterplatte auf. Mit "biegeelastisch" ist in diesem Zusammenhang gemeint, dass der jeweilige Leiterplattenabschnitt mit dem jeweiligen Steg viele Male, insbesondere mindestens 25 Mal und vorzugsweise mindestens 100 Mal, zwischen der ebenen Position und der für die optische Rauchdetektion vorgesehenen Schwenkposition hin- und her geschwenkt werden kann, ohne dass der jeweilige Steg signifikant in seiner Materialstruktur geschädigt wird, d.h. die leitfähigen Strukturen im Steg nicht unterbrochen sind.

Die Steglänge eines jeweiligen Stegs liegt insbesondere in einem Bereich von 1.5 cm bis 5 cm, vorzugsweise in einem Bereich von 2 bis 3.5 cm.

Der besondere Vorteil der Erfindung liegt zum einen darin, dass das Schwenken eines Leiterplattenabschnitts in die für die optische Rauchdetektion vorgesehene Schwenkposition in reproduzierbar mechanisch zulässigen Grenzen für das Leiterplattenmaterial, d.h. des Basismaterials erfolgt. Durch das biegeelastische Verformen des jeweiligen Stegs ist die gesamte Leiterplatte mit den aufgeschwenkten Leiterplattenabschnitten unempfindlich gegen zulässige mechanische Einwirkungen von außen, wie z.B. gegen Schock und Vibrationstest basierend auf einem Standard oder einer Norm für Brandmelder.

Ein weiterer Vorteil liegt darin, dass auf den Verarbeitungsschritt zur Verjüngung des Schwenkbereichs mittels Abtragung verzichtet werden kann.

Weiter vorteilhaft ist, dass die durchgehenden Ausnehmungen für die Leiterplattenabschnitte mittels eines Bohr-/Fräswerkzeugs auf einmal in einen Stapel mit einer Vielzahl gleicher Leiterplatten eingebracht werden können.

Da die Leiterplatten in Rauchmeldern typischerweise konturgefräst werden, ist der zusätzliche Bearbeitungsaufwand für die Einbringung der Ausnehmungen sehr gering.

Nach einer Ausführungsform weist der jeweilige Leiterplattensteg eine im Wesentlichen einheitliche Stegbreite auf, insbesondere in einem Bereich von 0.5 mm bis 3 mm, vorzugsweise in einem Bereich von 0.6 mm bis 1.5 mm.

Einer weiteren Ausführungsform zufolge weist der jeweilige Steg eine derart bemessene Steglänge auf, dass ein in der Schwenkposition in den jeweiligen Steg eingebrachtes Torsions- und/oder Biegemoment sich im Wesentlichen gleichmäßig entlang der Längserstreckung des jeweiligen Stegs abbaut.

Nach einer besonderen Ausführungsform weist der jeweilige Steg eine derart bemessene Steglänge auf, dass ein in der Schwenkposition in den jeweiligen Steg eingebrachtes Biege-/Torsionsmoment sich entlang der Längserstreckung des jeweiligen Stegs vorzugsweise gleichmäßig abbaut. Dadurch ist eine minimale Steglänge erreichbar.

Einer weiteren Ausführungsform zufolge ist die Leiterplatte aus einem Basismaterial hergestellt. Es ist die jeweilige Steglänge zudem derart bemessen, dass ein für das Basismaterial spezifizierter, maximal zulässiger Wert für die Biegefestigkeit nicht überschritten wird.

Insbesondere liegt der maximale Wert für die Biegefestigkeit des Basismaterials in einem Bereich von 200 N/mm² bis 600 N/mm², vorzugsweise in einem Bereich von 200 N/mm² bis 450 N/mm², und zwar unabhängig von einer strukturellen Vorzugsrichtung (cross, perpendicular) des Basismaterials.

Das Basismaterial ist vorzugsweise ein kostengünstiges FR4- oder FR2-Basismaterial mit einer oder mehreren Kupferlagen.

Nach einer bevorzugten Ausführungsform ist der jeweilige Steg mäanderförmig ausgeformt oder stabförmig als Torsionsstab ausgeformt. Im ersten Fall nimmt der mäanderförmig ausgeformte Steg flächenmäßig wenig Raum ein. Die Schwenkanordnung ist daher vorteilhaft sehr kompakt. Im zweiten Fall erstreckt sich der Torsionsstab linienförmig und ist fertigungstechnisch auf besonders einfache Weise in das Leiterplattenmaterial einbringbar.

Einer weiteren Ausführungsform zufolge weist der Rauchmelder eine auf der Leiterplatte angeordnete Steuer- und Auswerteeinheit auf. Die Steuer- und Auswerteeinheit ist typischerweise ein prozessorgestützter Mikrocontroller. Es sind auf einem ersten der beiden Abschnitte der Lichtsender, ein ansteuerbares Schaltelement sowie ein elektrischer Energiespeicher (Kondensator) angeordnet. Es verlaufen zwischen dem ersten Abschnitt und der Steuer- und Auswerteeinheit zumindest zwei Leiterbahnen über den zumindest einen Steg entlang dessen Längserstreckung. Es sind die zumindest zwei Leiterbahnen zur gepufferten Stromversorgung und zur elektrisch gepulsten Ansteuerung des Lichtsenders durch die Steuer- und Auswerteeinheit vorgesehen. Durch die Strompufferung entfällt die sonst sehr hohe, kurzzeitige Strombelastung der Leiterbahnen entlang des Stegs bei einer kurzzeitigen Ansteuerung des Lichtsenders. Typischerweise liegt die Pulsfrequenz für die Ansteuerung des Lichtsenders im Bereich von 0.1 bis 2 Hz, und die Dauer eines Strompulses im Bereich von 0.1 bis 1 ms. Auf diesem Wege kann der Kondensator zwischen zwei Pulsen ausreichend nachgeladen werden. Wegen der Strompufferung sind die ohmschen Verluste sehr gering und vernachlässigbar.

Nach einer weiteren Ausführungsform weist der optische Rauchmelder eine auf der Leiterplatte angeordnete Steuer- und Auswerteeinheit, wie z.B. einen Mikrocontroller, auf. Es sind auf einem zweiten der beiden Abschnitte nun der Lichtempfänger sowie ein damit verbundener Verstärker angeordnet Der Verstärker kann auch in dem Lichtempfänger integriert sein. Es verlaufen zwischen dem zweiten Abschnitt und der Steuer- und Auswerteeinheit zumindest zwei Leiterbahnen über den zumindest einen Steg entlang dessen Längserstreckung. Es sind die zumindest zwei Leiterbahnen zur Stromversorgung des Lichtempfängers und des Verstärkers sowie zur messtechnischen Erfassung eines vom Verstärker ausgegebenen verstärkten Photosignals durch die Steuer- und Auswerteeinheit vorgesehen.

Durch die Anordnung des Verstärkers in vorzugsweise direkter Nachbarschaft zum Lichtempfänger (Photodiode) wird eine mögliche EMV-Einkopplung in das noch nicht verstärkte Photosignal stark reduziert. Der Verstärker weist vorzugsweise einen A/D-Umsetzer zur Umsetzung des Photosignals vom Lichtempfänger in einen entsprechenden Digitalwert auf. Weiterhin umfasst der Verstärker einen digitalen, vorzugsweise seriellen Ausgang zur gesicherten Übertragung des Digitalwerts über den Steg und weiter zur Steuer- und Auswerteeinheit. Letztere ist zur nachfolgenden Auswertung des empfangenen digitalisierten Photosignals auf Brandkenngrößen hin sowie zur Ausgabe eines Brandalarms im detektierten Brandfall, wie z.B. an eine angeschlossene Brandmeldezentrale, eingerichtet bzw. programmiert.

Einer weiteren Ausführungsform zufolge ist der jeweilige Steg in der fixierten Schwenkposition zur mechanischen Entlastung des jeweiligen Stegs, d.h. zur kraft- und/oder torsionsmäßigen Entlastung des jeweiligen Stegs, mit einer aushärtenden Vergussmasse versehen. Nach Aushärtung verläuft dann zumindest ein Teil des Kraft- und/oder Momentenflusses über die ausgehärtete Vergussmasse. Dadurch wird der jeweilige Steg vorteilhaft mechanisch entlastet.

Nach einer bevorzugten Ausführungsform sind der Lichtsender und der Lichtempfänger derartig auf dem jeweiligen Leiterplattenabschnitt angeordnet und optisch ausgerichtet, dass der Lichtsender und der Lichtempfänger in der fixierten Schwenkposition in einer Streulichtanordnung oder in einer Durchlichtanordnung angeordnet sind.

Die Streulichtanordnung wie auch die Durchlichtanordnung kann Teil einer optischen Messkammer sein, die in einem Meldergehäuse des optischen Rauchmelders angeordnet ist. Das Meldergehäuse weist in diesem Fall eine oder mehrere Raucheintrittsöffnungen auf. Über diese können zu detektierende Rauchpartikel in das Innere des Gehäuses und somit in die optische Messkammer gelangen. Letztere ist durchlässig für die zu detektierenden Rauchpartikel. Üblicherweise ist die optische Messkammer, die auch als Labyrinth bezeichnet wird, gegenüber direktem Umgebungslicht abgeschirmt.

Alternativ kann der optische Rauchmelder auch ein offener Streulichtrauchmelder mit einem außerhalb des Meldergehäuses liegenden Messvolumen sein. Das Messvolumen wird im Fall eines Streulichtrauchmelders auch als Streulichtvolumen bezeichnet. Der Lichtsender und der Lichtempfänger sind optisch auf das gemeinsame Messvolumen ausgerichtet, und - wie auch die Leiterplatte - im Meldergehäuse angeordnet.

Einer weiteren Ausführungsform zufolge weist die Schwenkposition des zumindest einen Leiterplattenabschnitts einen Winkel im Bereich von 30° bis 60° auf. Der Lichtsender und Lichtempfänger sind in einer Streulichtanordnung angeordnet und auf ein gemeinsames Streulichtvolumen ausgerichtet. Das Messvolumen liegt im Bezug auf die Anordnung des Lichtsenders und/oder des Lichtempfängers auf einer Montageseite der Leiterplatte auf einer gegenüberliegenden Seite der Leiterplatte. Es weist die Leiterplatte eine jeweilige, insbesondere als Blende fungierende Durchgangsöffnung zur optischen Begrenzung eines Abstrahlbereichs des Lichtsenders und/oder zur optischen Begrenzung eines Empfangsbereichs des Lichtempfängers auf. Dadurch ist eine besonders kompakte Bauform mit bereits in der Leiterplatte integrierten Blenden möglich.

Nach einer weiteren Ausführungsform sind der Lichtsender und der Lichtempfänger in einer Streulicht- oder Durchlichtanordnung angeordnet. Es liegt ein jeweiliges Messvolumen für die Streulicht- oder Durchlichtdetektion einer Montageseite der Leiterplatte gegenüber. Der optische Rauchmelder weist eine Abdeckung mit lichtabsorbierenden Strukturen hin zum Messvolumen auf. Die Abdeckung grenzt an dieser Montageseite an. Durch die Abdeckung, die vorzugsweise aus einem schwarzen Kunststoff hergestellt ist, wird das nicht für die optische Rauchdetektion emittierte Licht weitgehend eliminiert.

Insbesondere weist die Abdeckung Aussparungen für den Lichtsender und/oder für den Lichtempfänger auf.

Weiterhin sind die Aussparungen zusätzlich zur optischen Begrenzung eines Abstrahlbereichs des Lichtsenders und/oder zur optischen Begrenzung eines Empfangsbereichs des Lichtempfängers im Sinne einer Blende vorgesehen.

Einer weiteren Ausführungsform zufolge weist die Abdeckung angrenzend zu einer jeweiligen Aussparung für den Lichtsender und/oder für den Lichtempfänger zumindest eine weg von der abzudeckenden Montageseite der Leiterplatte zeigende Halterung auf. Es ist die jeweilige Halterung zur Fixierung eines hindurchragenden, aufgeschwenkten Leiterplattenabschnitts mit dem Lichtsender und/oder eines hindurchragenden, aufgeschwenkten Leiterplattenabschnitts mit dem Lichtempfänger in der jeweiligen Schwenkposition vorgesehen.

Schließlich weist die Abdeckung für den Lichtsender und/oder für den Lichtempfänger zumindest eine in Richtung hin zur abzudeckenden Montageseite der Leiterplatte zeigende Halterung auf. Es ist die jeweilige Halterung zum Aufschwenken und zur anschließenden, insbesondere verrastenden Fixierung eines aufgeschwenkten Leiterplattenabschnitts mit dem Lichtsender und/oder eines aufgeschwenkten Leiterplattenabschnitts mit dem Lichtempfänger in der jeweiligen Schwenkposition vorgesehen.

Das Aufschwenken vorzugsweise beider Leiterplattenabschnitte erfolgt während der Montage des Rauchmelders mittels der in der (Kunststoff-)Abdeckung integrierten Halterungen. Die Abdeckung bildet zugleich den Messkammerboden. Die Halterungen weisen eine schräge Kante zum Aufschwenken der Leiterplattenabschnitte im Sinne einer schiefen Ebene sowie Rastelemente zum Verrasten der Halterungen mit dem jeweiligen Leiterplattenabschnitt auf. Die Halterungen können zugleich als Blende und optischen Abschirmung dienen.

### FIGURENBESCHREIBUNG

Die Erfindung sowie vorteilhafte Ausführungen der vorliegenden Erfindung werden am Beispiel der nachfolgenden Figuren erläutert. Dabei zeigen:
- FIG 1: ein Beispiel für eine Leiterplatte eines optischen Rauchmelders gemäß der Erfindung mit zwei aufschwenkbaren Leiterplattenabschnitten in einer Draufsicht,
- FIG 2: das Beispiel gemäß FIG 1 im aufgeschwenkten Zustand um 90° und in einer Seitenansicht,
- FIG 3: ein weiteres Beispiel für eine Leiterplatte mit zwei aufschwenkbaren Leiterplattenabschnitten mit jeweils einer als Blende fungierende Durchgangsöffnung gemäß der Erfindung in einer Draufsicht,
- FIG 4: das Beispiel gemäß FIG 3 im aufgeschwenkten Zustand um 60° in einer Streulichtanordnung und in einer Seitenansicht,
- FIG 5: ein erstes Beispiel eines aufschwenkbaren Leiterplattenabschnitts mit mäanderförmigem Leiterplattensteg gemäß der Erfindung in einer Draufsicht,
- FIG 6: ein zweites Beispiel eines aufschwenkbaren Leiterplattenabschnitts mit mäanderförmigem Leiterplattensteg gemäß der Erfindung in einer Draufsicht,
- FIG 7: das Beispiel gemäß FIG 5 im aufgeschwenkten und verrasteten Zustand mit einer Halterung gemäß der Erfindung in einer Seitenansicht,
- FIG 8: ein Beispiel für eine Leiterplatte mit zwei um 30° aufgeschwenkten Leiterplattenabschnitten mit einer Sideemitter-LED und einer Sidelooker-Photodiode gemäß der Erfindung in einer Seitenansicht,

- FIG 9: ein weiteres Beispiel mit nur einem um 30° aufgeschwenkten Leiterplattenabschnitt mit einer Sideemitter-LED gemäß der Erfindung in einer Seitenansicht, und
- FIG 10: ein Beispiel für einen offenen optischen Rauchmelder mit einem außerhalb des Rauchmelders liegendem Streulichtvolumen gemäß der Erfindung mit zwei um 60° aufgeschwenkten Leiterplattenabschnitten.

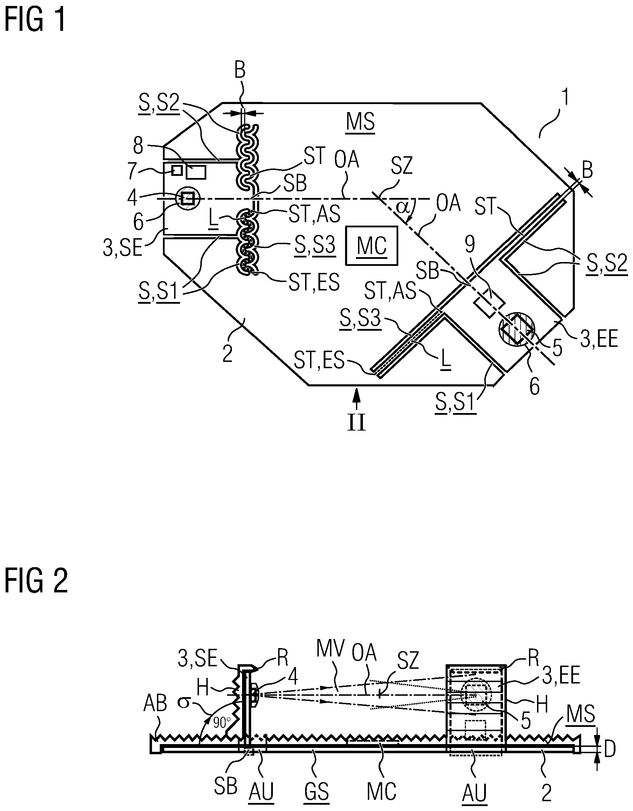

FIG 1 zeigt ein Beispiel für eine Leiterplatte 2 eines optischen Rauchmelders mit zwei aufschwenkbaren Leiterplattenabschnitten 3 gemäß der Erfindung in einer Draufsicht.

Mit dem Bezugszeichen 1 ist eine optische Rauchdetektionsanordnung bezeichnet. Es wurde aus Gründen der Übersichtlichkeit, wie auch im Folgenden, auf die Darstellung eines Meldergehäuses verzichtet. Typischerweise ist eine derartige Rauchdetektionsanordnung 1 im Meldergehäuse untergebracht. Die optische Rauchdetektionsanordnung umfasst die Leiterplatte 2 sowie eine darauf angeordnete LED als Lichtsender 4, eine Photodiode als Lichtempfänger 5 sowie einen Mikrocontroller MC als Steuer- und Auswerteeinheit jeweils als SMD-Bauteil. Mit dem Bezugszeichen 6 ist ferner eine optische Linse für die LED 4 und für die Photodiode 5 bezeichnet. MS bezeichnet eine Montageseite der Leiterplatte 2.

Gemäß der vorliegenden Erfindung sind der Lichtsender 4 und der Lichtempfänger 5 jeweils auf einem Abschnitt 3 der Leiterplatte 2 angeordnet. Beide Abschnitte 3 sind noch nicht aufgeschwenkt und befinden sich somit in einer ebenen Position in einer gemeinsamen Ebene mit der gezeigten Leiterplatte 2. Beide Leiterplattenabschnitte 3 sind bis auf jeweils zwei verbleibenden Stege ST durch jeweils drei durchgehende Ausnehmung S1-S3 in der Leiterplatte 2 ausgeformt. Die gezeigten Ausnehmungen S, S1-S3 sind im vorliegenden Beispiel mittels eines Fräskopfes in die Leiterplatte 2 eingebracht. Die so eingebrachten Ausnehmungen S, S1-S3 weisen daher eine Mindestbreite auf, die der Breite bzw. dem Durchmesser des Fräskopfes entspricht. Im vorliegenden Beispiel verbleiben somit je zwei Stege ST jeweils mit einer Stegbreite B für jeden Leiterplattenabschnitt 3. Die beiden Stege ST des linken Leiterplattenabschnitts 3 sind weiter gemäß der Erfindung mäanderförmig ausgeformt und die beiden Stege ST des rechten Leiterplattenabschnitts 3 stabförmig als Torsionsstab ausgeformt. Mit SB ist ein Schwenkbereich bezeichnet, um den sich der jeweilige Leiterplattenschnitt 3 entlang der beiden Stege ST schwenken lässt. Weiterhin ist mit AS der jeweilige Steganfang, mit ES das jeweilige Stegende und mit L eine zugehörige Steglänge bezeichnet.

Gemäß der Erfindung weist der jeweilige Steg ST nun eine derart bemessene Steglänge L auf, dass in der vorgesehenen Schwenkposition von hier 90° (siehe auch FIG 2) ein in den jeweiligen Steg ST eingebrachtes Biege- und/oder Torsionsmoment den jeweiligen Steg SG biegeelastisch verformt. Im vorliegenden Beispiel ist in die beiden linken Stege ST ein kombiniertes Biege- und Torsionsmoment und in die beiden rechten Stege ST nur ein Torsionsmoment eingebracht. Zum gleichmäßigen Abbau des jeweiligen eingebrachten Biege- und Torsionsmoments sind die gezeigten Stege ST gleichförmig ausgebildet, wie hier sinus- oder linienförmig. Der Abbau erfolgt entlang der gezeigten Steglänge L in den mechanisch zulässigen Grenzen eines für die Leiterplatte verwendeten Basismaterials, wie z.B. von FR4. Die Steglänge L beträgt im vorliegenden Beispiel zwischen zwei und drei Zentimeter.

OA bezeichnet weiter die jeweilige optische Achse des Lichtsenders 4 sowie des Lichtempfängers 5, die auch nach dem Ausschwenken der beiden gezeigten Leiterplattenabschnitte 3 aus der gezeigten Blattebene erhalten bleibt. Die beiden Schwenkungen erfolgen somit entlang einer gedachten Schwenklinie in der Leiterplattenebene, die jeweils orthogonal zur zugehörigen optischen Achse OA verläuft. In der dann vorgesehenen Schwenkposition (siehe nachfolgende FIG 2) treffen sich beide optische Achsen OA idealerweise, jedoch nicht notwendiger konstruktiv in einem Streulichtzentrum SZ. Mit dem eingezeichneten Winkel α ist ein dazwischenliegender Streulichtwinkel für eine optische Streulichtrauchdetektion bezeichnet. Der Streulichtwinkel α weist hier einen beispielhaften Winkelwert von 45° auf.

Der gezeigte linke Leiterplattenabschnitt 3 bildet zusammen mit den darauf angebrachten SMD-Bauteilen 4, 7, 8 eine optische Sendereinheit SE. Mit dem Bezugszeichen 7 ist ein FET-Schalttransistor und mit 8 ein Kondensator zur Strompufferung bezeichnet. Der gezeigte rechte Leiterplattenabschnitt 3 bildet zusammen mit den darauf angebrachten SMD-Bauteilen 5, 9 eine optische Empfängereinheit EE. Mit dem Bezugszeichen 9 ist ein Verstärker mit digitalem Ausgang für ein von der Photodiode 5 ausgegebenes verstärktes Photosignal bezeichnet.

FIG 2 zeigt das Beispiel gemäß FIG 1 im aufgeschwenkten Zustand um einen Schwenkwinkel σ von 90° und in einer Seitenansicht. In dieser für die optische Rauchdetektion vorgesehenen Schwenkposition sind beide Leiterplattenabschnitte 3, und somit die optische Sendereinheit SE wie auch die optische Empfängereinheit EE jeweils durch eine Halterung H fixiert. Die beiden Halterungen H sind integraler Teil einer Abdeckung AB aus Kunststoff mit lichtabsorbierenden, gezahnten Strukturen. In der Abdeckung AB ist jeweils eine Aussparung AU vorhanden, so dass die aufgeschwenkten Leiterplattenabschnitte 3 durch die Aussparungen AU hindurchgeführt werden können und über jeweils einer Rastnase R hinweg mit der entsprechenden Halterung H verrastet und somit fixiert werden können. Mit dem Verrasten liegt auch die Montageseite MS der Leiterplatte 2 flächig an der Abdeckung AB an und bildet mit dieser zusammen einen Verbund. Mit GS ist ferner eine gegenüberliegende Leiterplattenseite zur Montageseite MS und mit D eine einheitliche Leiterplattendicke bezeichnet.

Wie die vorliegende FIG 2 weiter zeigt, liegen die beiden optischen Achsen OA in einer Ebene parallel zur Leiterplattenebene. Sie treffen sich im Streulichtzentrum SZ. Mit MV ist ein Messvolumen bzw. Streulichtvolumen bezeichnet. Auf dieses Streulichtvolumen sind der Lichtsender 4 und der Lichtempfänger 5 optisch ausgerichtet.

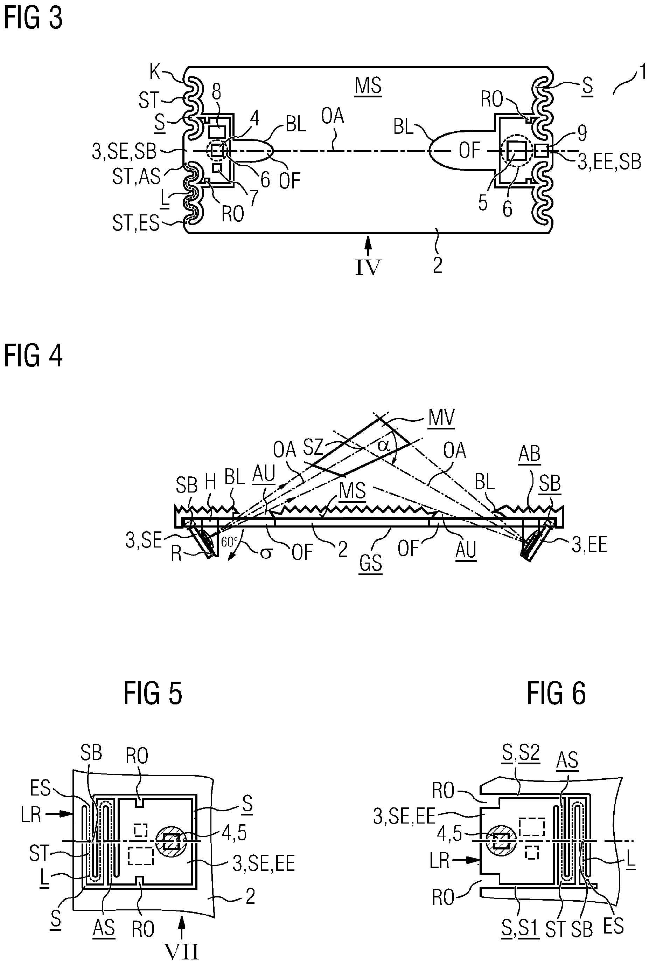

FIG 3 zeigt ein weiteres Beispiel für eine Leiterplatte 2 mit zwei aufschwenkbaren Leiterplattenabschnitten 3 mit jeweils einer als Blende BL fungierende Durchgangsöffnung OF gemäß der Erfindung und in einer Draufsicht. Es sind beide Leiterplattenabschnitte 3 nicht aufgeschwenkt. Mit K ist eine Außenkontur der Leiterplatte 2 bezeichnet, die typischerweise im Rahmen der Leiterplattenfertigung aufgebracht wird. Die gezeigte Leiterplatte 2 ist, wie auch die Leiterplatte 2 im vorhergehenden Beispiel, somit konturgefräst. Im Rahmen dieser Konturierung ist bereits vorteilhaft ein Teil der gezeigten Stege ST ausgeformt. Der verbleibende Teil der Stege ST ist durch mäanderförmige und linienförmige Ausnehmungen S realisiert, die auch die jeweiligen Durchgangsöffnungen OF mit umfassen. Die gezeigten Ausnehmungen S werden vorzugsweise mittels eines Fräskopfes eingebracht. Sie umfassen zudem kleinere Rastöffnungen RO, die zum Verrasten und Fixierung mit einer jeweiligen Halterung H dienen.

FIG 4 zeigt das Beispiel gemäß FIG 3 im aufgeschwenkten Zustand um 60° in einer Streulichtanordnung und in einer Seitenansicht. Zu sehen ist, wie ein optischer Abstrahlbereich des Lichtsenders 4 sowohl durch die Durchgangsöffnung OF in der Leiterplatte 2 als auch durch eine Aussparung AU in der Abdeckung AB für die Leiterplatte 2 hindurchtritt. Im vorliegenden Fall dient diese Aussparung AU als Blende BL. Im rechten Teil der FIG 4 dient gleichfalls eine zugehörige Aussparung AU in der Abdeckung AB als Blende BL für den Lichtempfänger 5 auf dem aufgeschwenkten Leiterplattenabschnitt 3. In der vorliegenden Figur ist wiederum das Streulichtvolumen MV zu sehen sowie ein zwischen den beiden optischen Achsen OA gebildeter Streulichtwinkel a. Letzerer weist einen Winkelwert von 60° auf.

FIG 5 zeigt ein erstes Beispiel eines aufschwenkbaren Leiterplattenabschnitts 3 mit mäanderförmigem Leiterplattensteg ST gemäß der Erfindung in einer Draufsicht. Mit LR ist ein linker Rand der Leiterplatte 2 bezeichnet, zu dem hin der gezeigte Leiterplattenabschnitt 3 geschwenkt werden kann. Der Leiterplattenabschnitt 3 ist in diesem Beispiel nur über einen einzigen Steg ST mit der restlichen Leiterplatte 2 verbunden. Über diesen Steg ST sind auch die nicht weiter eingezeichneten Leiterbahnen vom Leiterplattenabschnitt 3 zur restlichen Leiterplatte 3 und weiter zum Mikrocontroller geführt. Im Falle von drei Leiterbahnen können zwei an den beiden Außenseiten MS, GS der Leiterplatte 2 und eine dritte als Teil einer Innenlage der Leiterplatte 2 geführt sein.

FIG 6 zeigt ein zweites Beispiel eines aufschwenkbaren Leiterplattenabschnitts 3 mit mäanderförmigem Leiterplattensteg ST gemäß der Erfindung in einer Draufsicht. Im Unterschied zur vorherigen FIG 5 erfolgt hier eine Schwenkung weg vom linken Rand LR hin zur Mitte der Leiterplatte 2.

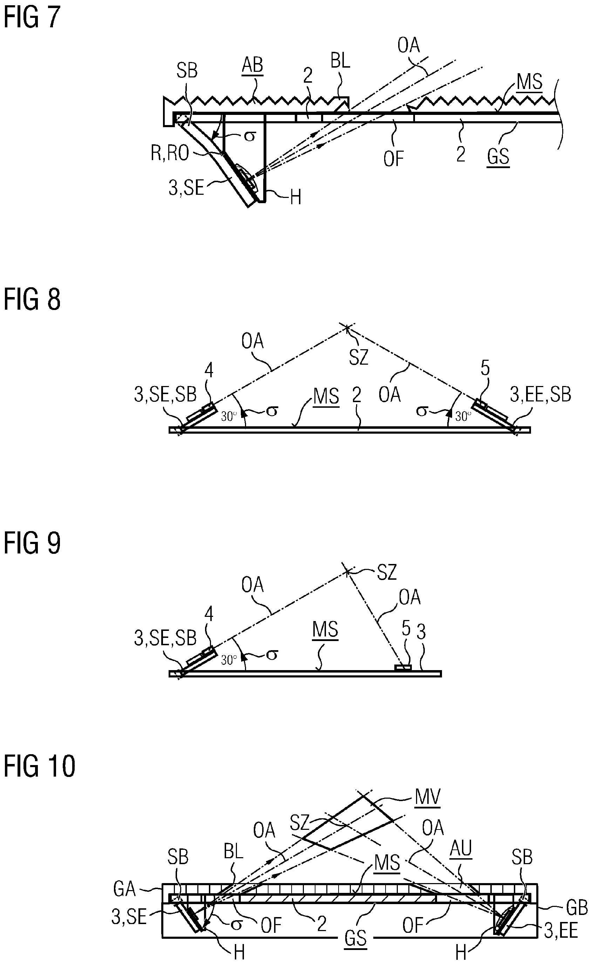

FIG 7 zeigt das Beispiel gemäß FIG 5 im aufgeschwenkten und verrasteten Zustand mit einer Halterung H gemäß der Erfindung in einer Seitenansicht.

Die gezeigte Halterung H weist gemäß der Erfindung eine schräge Kante auf, so dass der gezeigte Leiterplattenabschnitt 3 ausgehend von einer ebenen Position in einer Ebene zur Leiterplatte 2 nun entlang einer schiefen Ebene aufgeschwenkt wird, während die gezeigte Abdeckung AB im Rahmen der Montage hin zur Montageseite MS der Leiterplatte 2 bewegt wird. Mit dem dann flächigen Anlegen der Abdeckung A an die Montageseite MS ist auch die vorgesehene Schwenkposition erreicht. Die Halterung H weist zudem eine Rastnase R auf, die konstruktiv so an der Halterung H ausgebildet ist, dass mit dem Erreichen der Schwenkposition die Rastnase R mit einer zugehörigen Rastöffnung RO am Leiterplattenabschnitt 3 verrasten kann. Der Leiterplattenabschnitt 3 ist nun fixiert.

FIG 8 zeigt ein Beispiel für eine Leiterplatte 2 mit zwei um 30° aufgeschwenkten Leiterplattenabschnitten 3 mit einer sogenannten Sideemitter-LED 4 und mit einer sogenannten Sidelooker-Photodiode 5 gemäß der Erfindung in einer Seitenansicht. Beide optoelektronischen Bauelemente 4, 5 sind wiederum SMD-Bauelemente. Wie die Namensbezeichnung bereits anzeigt, erfolgt die Lichtaussendung wie auch die Lichtdetektion nicht in Normalenrichtung zur Montageseite, sondern um 90° quer dazu. Der besondere Vorteil liegt hier darin, dass der Schwenkwinkel σ einen besonders kleinen Winkelwert von nur 30° aufweist. Dadurch kann der jeweilige Steg ST eine vergleichsweise kurze Steglänge L aufweisen.

FIG 9 zeigt ein weiteres Beispiel mit einem einzigen aufgeschwenkten Leiterplattenabschnitt gemäß der Erfindung und in einer Seitenansicht. Auf dem Leiterplattenabschnitt 3 ist eine Sideemitter-LED angeordnet. In diesem Beispiel weist die gesamte Leiterplatte 2 nur einen einzigen schwenkbar ausgebildeten Leiterplattenabschnitt 3 für den Lichtsender 4 auf, während der zweite Leiterplattenabschnitt 3 nicht schwenkbar ausgebildet ist. Letzter ist von keinen Ausnehmungen umgeben.

FIG 10 zeigt ein Beispiel für einen offenen optischen Rauchmelder mit einem außerhalb des Rauchmelders liegendem Streulichtvolumen MV gemäß der Erfindung und mit zwei um 60° aufgeschwenkten Leiterplattenabschnitten 3. Mit GA ist eine Gehäuseabdeckung bzw. eine Haube als Teil eines Meldergehäuses bezeichnet. Mit GB ist ein Gehäuseboden als weiterer Teil des Meldergehäuses bezeichnet. Er dient zur Aufnahme der gesamten optischen Rauchdetektionsanordnung 1 mit der Leiterplatte 2. Zudem ist der Gehäuseboden GB zur Anbringung an einer Montagefläche wie an einer Decke oder an einer Wand vorgesehen. Die Gehäuseabdeckung GA weist Aussparungen AU auf, sodass Licht vom Lichtsender 4 und dann weiter über eine Durchgangsöffnung OF in der Leiterplatte 2 ins Freie gelangen kann. Auf umgekehrtem Wege gelangt Streulicht von Partikeln im Streulichtvolumen MV über die andere Aussparung AU und dann weiter über eine weitere Durchgangsöffnung OF in der Leiterplatte 2 in der Gehäuseabdeckung GA zum Lichtempfänger 4 im Inneren des Meldergehäuses. Beide Aussparungen AU fungieren wiederum als Blende BL. Die gezeigte Anordnung weist vorteilhaft eine äußerste kompakte Bautiefe auf.

### SCHLUSSBEMERKUNG

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

### Bezugszeichenliste

- 1: optische Rauchdetektionsanordnung
- 2: Schaltungsträger, Leiterplatte
- 3: Abschnitt, Leiterplattenabschnitt
- 4: Lichtsender, LED, Laserdiode
- 5: Lichtsensor, Photosensor, Photodiode
- 6: Linse, optisches Element
- 7: Schaltelement, FET, Schalttransistor
- 8: Energiespeicher, Kondensator
- 9: Vorverstärker
- α: Streulichtwinkel
- σ: Schwenkwinkel
- AB: Abdeckung, absorbierende Strukturen
- AS: Anfang des Stegs
- AU: Aussparung
- B: Stegbreite
- BL: Blende
- D: Plattendicke, Leiterplattendicke
- EE: optische Empfängereinheit
- ES: Ende des Stegs
- GA: Gehäuseabdeckung, Haube
- GB: Gehäuseboden
- GS: gegenüberliegende Seite, Außenseite
- H: Halterung, Halterung mit Schwenk-/Fixierelement
- K: Randkontur der Leiterplatte
- L: Steglänge
- LR: Leiterplattenrand, Außenrand
- MC: Steuer- und Auswerteeinheit, Mikrocontroller
- MS: Messkammerseite, Montageseite
- MV: Messvolumen, Streulichtvolumen
- OA: optische Achse, optische Hauptachse
- OF: Öffnung, Durchlassöffnung
- R: Raste, Rastelement, Rastnase
- RO: Rastöffnung
- S, S1-S3: Ausnehmung, Schlitz, Längsschlitz
- SB: Schwenkbereich, Schwenklinie
- SE: optische Sendereinheit
- ST: Leiterplattensteg, Steg
- SZ: Streulichtzentrum

## Patentansprüche

1. Optischer Rauchmelder, welcher eine Leiterplatte (2) mit einer einheitlichen Leiterplattendicke (D) sowie einen Lichtsender (4) und einen Lichtempfänger (5) aufweist, wobei der Lichtsender (4) und der Lichtempfänger (5) jeweils auf einem Abschnitt (3) der Leiterplatte (2) angeordnet sind und wobei der jeweilige Leiterplattenabschnitt (3) aus einer ebenen Position in einer gemeinsamen Ebene mit der Leiterplatte (2) in eine für die optische Rauchdetektion vorgesehene Schwenkposition schwenkbar und fixierbar ist, **dadurch gekennzeichnet,**
- **dass** die Schwenkposition einen Winkel (σ) in einem Bereich von 30° bis 90° aufweist,
- **dass** zumindest einer der beiden Leiterplattenabschnitte (3) jeweils bis auf zumindest einen verbleibenden Steg (ST) durch zumindest eine durchgehende Ausnehmung (S) in der Leiterplatte (2) ausgeformt ist, und
- **dass** der jeweilige Steg (ST) eine derart bemessene Steglänge (L) aufweist, dass ein in der Schwenkposition in den jeweiligen Steg (ST) eingebrachtes Biege- und/oder Torsionsmoment den jeweiligen Steg (ST) biegeelastisch verformt.

2. Optischer Rauchmelder nach Anspruch 1, wobei der jeweilige Steg (ST) die einheitliche Leiterplattendicke (D) und eine im Wesentlichen einheitliche Stegbreite (B) aufweist, insbesondere in einem Bereich von 0.5 mm bis 3 mm.

3. Optischer Rauchmelder nach Anspruch 1 oder 2, wobei der jeweilige Steg (ST) eine derart bemessene Steglänge (L) aufweist, dass ein in der Schwenkposition in den jeweiligen Steg (ST) eingebrachtes Biege-/Torsionsmoment sich entlang der Längserstreckung des jeweiligen Stegs (ST) abbaut.

4. Optischer Rauchmelder nach Anspruch 3, wobei die Leiterplatte (2) aus einem Basismaterial, insbesondere aus einem FR4- oder FR2-Basismaterial, hergestellt ist und wobei die jeweilige Steglänge (L) zudem derart bemessen ist, dass ein für das Basismaterial spezifizierter, maximal zulässiger Wert für die Biegefestigkeit nicht überschritten wird.

5. Optischer Rauchmelder nach einem der vorherigen Ansprüche, wobei der jeweilige Steg (ST) mäanderförmig ausgeformt oder stabförmig als Torsionsstab ausgeformt ist.

6. Optischer Rauchmelder nach einem der vorherigen Ansprüche, wobei der Rauchmelder eine auf der Leiterplatte (2) angeordnete Steuer- und Auswerteeinheit (MC) aufweist, wobei auf einem ersten der beiden Abschnitte (3) der Lichtsender (4), ein ansteuerbares Schaltelement (7) sowie ein elektrischer Energiespeicher (8) angeordnet sind, wobei zwischen dem ersten Abschnitt (3) und der Steuer- und Auswerteeinheit (MC) zumindest zwei Leiterbahnen über den zumindest einen Steg (ST) entlang dessen Längserstreckung verlaufen, und wobei die zumindest zwei Leiterbahnen zur gepufferten Stromversorgung und zur elektrisch gepulsten Ansteuerung des Lichtsenders (4) durch die Steuer- und Auswerteeinheit (MC) vorgesehen sind.

7. Optischer Rauchmelder nach einem der vorherigen Ansprüche, wobei der Rauchmelder eine auf der Leiterplatte (2) angeordnete Steuer- und Auswerteeinheit (MC) aufweist, wobei auf einem zweiten der beiden Abschnitte (3) der Lichtempfänger (5) sowie ein damit verbundener Verstärker (9) angeordnet sind, wobei zwischen dem zweiten Abschnitt (3) und der Steuer- und Auswerteeinheit (MC) zumindest zwei Leiterbahnen über den zumindest einen Steg (ST) entlang dessen Längserstreckung verlaufen, und wobei die zumindest zwei Leiterbahnen zur Stromversorgung des Lichtempfängers (5) und des Verstärkers (9) sowie zur messtechnischen Erfassung eines vom Verstärker (9) ausgegebenen verstärkten Photosignals durch die Steuerund Auswerteeinheit (MC) vorgesehen sindf.

8. Optischer Rauchmelder nach einem der vorherigen Ansprüche, wobei der jeweilige Steg (ST) in der fixierten Schwenkposition zur zumindest teilweise mechanischen Entlastung des jeweiligen Stegs (ST) mit einer aushärtenden Vergussmasse versehen ist.

9. Optischer Rauchmelder nach einem der vorherigen Ansprüche, wobei der Lichtsender (4) und der Lichtempfänger (5) derartig auf dem jeweiligen Abschnitt (3) angeordnet und optisch ausgerichtet sind, dass der Lichtsender (4) und der Lichtempfänger (5) in der fixierten Schwenkposition in einer Streulichtanordnung oder in einer Durchlichtanordnung angeordnet sind.

10. Optischer Rauchmelder nach Anspruch 9, wobei die Schwenkposition des zumindest einen Leiterplattenabschnitts (3) einen Winkel (σ) im Bereich von 30° bis 60° aufweist, wobei der Lichtsender (4) und Lichtempfänger (5) in einer Streulichtanordnung angeordnet und auf ein gemeinsames Messvolumen (MV) ausgerichtet sind, wobei das Messvolumen (MV) im Bezug auf die Anordnung des Lichtsenders (4) und/oder des Lichtempfängers (5) auf einer Montageseite (MS) der Leiterplatte (2) auf einer gegenüberliegenden Seite (GS) der Leiterplatte (2) liegt und wobei die Leiterplatte (2) eine jeweilige, insbesondere als Blende (BL) fungierende Durchgangsöffnung (OF) zur optischen Begrenzung eines Abstrahlbereichs des Lichtsenders (4) und/oder zur optischen Begrenzung eines Empfangsbereichs des Lichtempfängers (5) aufweist.

11. Optischer Rauchmelder nach einem der vorherigen Ansprüche, wobei der Lichtsender (4) und der Lichtempfänger (5) in einer Streulicht- oder Durchlichtanordnung angeordnet sind, wobei ein Messvolumen (MV) für die Streulicht- oder Durchlichtdetektion einer Montageseite (MS) der Leiterplatte (2) gegenüberliegt, wobei der optische Rauchmelder eine Abdeckung (AB) hin zum Messvolumen (MV) mit lichtabsorbierenden und/oder lichtreflektierenden Strukturen aufweist, und wobei die Abdeckung (AB) an dieser Montageseite (MS) angrenzt.

12. Optischer Rauchmelder nach Anspruch 11, wobei die Abdeckung (AB) Aussparungen (AU) für den Lichtsender (4) und/oder für den Lichtempfänger (5) aufweist.

13. Optischer Rauchmelder nach Anspruch 12, wobei die Aussparungen (AU) zudem zur optischen Begrenzung eines Abstrahlbereichs des Lichtsenders (4) und/oder zur optischen Begrenzung eines Empfangsbereichs des Lichtempfängers (5) im Sinne einer Blende (BL) vorgesehen sind.

14. Optischer Rauchmelder nach einem der Ansprüche 11 bis 13, wobei die Abdeckung (AB) angrenzend zu einer jeweiligen Aussparung (AU) für den Lichtsender (4) und/oder für den Lichtempfänger (5) zumindest eine weg von der abzudeckenden Montageseite (MS) der Leiterplatte (2) zeigende Halterung (H) aufweist, und wobei die jeweilige Halterung (H) zur Fixierung eines hindurchragenden, aufgeschwenkten Leiterplattenabschnitts (3) mit dem Lichtsender (4) und/oder eines hindurchragenden, aufgeschwenkten Leiterplattenabschnitts (3) mit dem Lichtempfänger (5) in der jeweiligen Schwenkposition vorgesehen ist.

15. Optischer Rauchmelder nach einem der Ansprüche 11 bis 13, wobei die Abdeckung (AB) für den Lichtsender (4) und/oder für den Lichtempfänger (5) zumindest eine in Richtung hin zur abzudeckenden Montageseite (MS) der Leiterplatte (2) zeigende Halterung (H) aufweist, und wobei die jeweilige Halterung (H) zum Aufschwenken und zur anschließenden, insbesondere verrastenden Fixierung eines aufgeschwenkten Leiterplattenabschnitts (3) mit dem Lichtsender (4) und/oder eines aufgeschwenkten Leiterplattenabschnitts (3) mit dem Lichtempfänger (5) in der jeweiligen Schwenkposition vorgesehen ist.

## Claims

1. Optical smoke detector, which has a circuit board (2) with a consistent circuit board thickness (D) as well as a light emitter (4) and a light receiver (5), wherein the light emitter (4) and the light receiver (5) are arranged on one section (3) of the circuit board (2) in each case and wherein the respective circuit board section (3) is able to be pivoted out from a flat position in a shared plane with the circuit board (2) into a pivoted position provided for the optical smoke detection and fixed, **characterised in that**
- the pivoted position has an angle (σ) in a range of from 30° to 90°,
- at least one of the two circuit board sections (3) is formed by at least one continuous recess (S) in the circuit board (2) up to at least one remaining web (ST) in each case, and
- the respective web (ST) has a web length (L) which is dimensioned such that a bending moment or torque introduced into the respective web (ST) in the pivoted position deforms the respective web (ST) in a flexible manner.

2. Optical smoke detector according to claim 1, wherein the respective web (ST) has the consistent circuit board thickness (D) and a substantially consistent web width (B), in particular in a range of from 0.5 mm to 3 mm.

3. Optical smoke detector according to claim 1 or 2, wherein the respective web (ST) has a web length (L) which is dimensioned such that a bending moment/torque introduced into the respective web (ST) in the pivoted position degrades along the longitudinal extension of the respective web (ST).

4. Optical smoke detector according to claim 3, wherein the circuit board (2) is manufactured from a base material, in particular from an FR4 or FR2 base material, and wherein the respective web length (L) is additionally dimensioned such that a maximum permitted value for the flexural strength which is specified for the base material is not exceeded.

5. Optical smoke detector according to one of the preceding claims, wherein the respective web (ST) is formed in a meandering pattern or is formed in a rod-shaped manner as a torsion rod.

6. Optical smoke detector according to one of the preceding claims, wherein the smoke detector has a control and evaluation unit (MC) arranged on the circuit board (2), wherein an actuatable switching element (7) and an electrical energy store (8) are arranged on a first of the two sections (3) of the light emitter (4), wherein at least two conducting paths run over the at least one web (ST) along the longitudinal extension thereof between the first section (3) and the control and evaluation unit (MC), and wherein the at least two conducting paths are provided for the buffered current supply and for the electrically pulsed actuation of the light emitter (4) by the control and evaluation unit (MC).

7. Optical smoke detector according to one of the preceding claims, wherein the smoke detector has a control and evaluation unit (MC) arranged on the circuit board (2), wherein the light receiver (5) and an amplifier (9) connected thereto are arranged on a second of the two sections (3), wherein at least two conducting paths run over the at least one web (ST) along the longitudinal extension thereof between the second section (3) and the control and evaluation unit (MC), and wherein the at least two conducting paths are provided for the current supply of the light receiver (5) and the amplifier (9) as well as for the acquisition in terms of measurement technology of an amplified photo signal output by the amplifier (9) by means of the control and evaluation unit (MC) .

8. Optical smoke detector according to one of the preceding claims, wherein the respective web (ST), in the fixed pivoted position, is provided with a hardened casting compound for at least partial mechanical load relief of the respective web (ST) .

9. Optical smoke detector according to one of the preceding claims, wherein the light emitter (4) and the light receiver (5) are arranged on the respective section (3) and optically oriented such that the light emitter (4) and the light receiver (5), in the fixed pivoted position, are arranged in a scattered light arrangement or in a shining-through light arrangement.

10. Optical smoke detector according to claim 9, wherein the pivoted position of the at least one circuit board section (3) has an angle (σ) in the range of from 30° to 60°, wherein the light emitter (4) and light receiver (5) are arranged in a scattered light arrangement and are oriented on a shared measurement volume (MV), wherein the measurement volume (MV), in relation to the arrangement of the light emitter (4) and/or the light receiver (5) on an assembly side (MS) of the circuit board (2), lies on an opposite side (GS) of the circuit board (2) and wherein the circuit board (2) has a respective through opening (OF), in particular functioning as an aperture (BL), for optically restricting a radiation range of the light emitter (4) and/or for optically restricting a receiving range of the light receiver (5).

11. Optical smoke detector according to one of the preceding claims, wherein the light emitter (4) and the light receiver (5) are arranged in a scattered light or shining-through light arrangement, wherein a measurement volume (MV) for the detection of scattered light or shining-through light lies opposite an assembly side (MS) of the circuit board (2), wherein the optical smoke detector has a covering (AB) towards the measurement volume (MV) with light-absorbing and/or lightreflecting structures, and wherein the covering (AB) adjoins said assembly side (MS).

12. Optical smoke detector according to claim 11, wherein the covering (AB) has recesses (AU) for the light emitter (4) and/or for the light receiver (5).

13. Optical smoke detector according to claim 12, wherein the recesses (AU) are additionally provided for optically restricting a radiation range of the light emitter (4) and/or for optically restricting a receiving range of the light receiver (5) in the sense of an aperture (BL).

14. Optical smoke detector according to one of claims 11 to 13, wherein the covering (AB), adjoining a respective recess (AU) for the light emitter (4) and/or for the light receiver (5), has at least one retainer (H) pointing away from the assembly side (MS) of the circuit board (2) to be covered, and wherein the respective retainer (H) is provided for the fixing of a circuit board section (3), which is protruding through and is pivoted, to the light emitter (4) and/or of a circuit board section (3), which is protruding through and is pivoted, to the light receiver (5) in the respective pivoted position.

15. Optical smoke detector according to one of claims 11 to 13, wherein the covering (AB) for the light emitter (4) and/or for the light receiver (5), has at least one retainer (H) pointing in the direction towards the assembly side (MS) of the circuit board (2) to be covered, and wherein the respective retainer (H) is provided for the pivoting and for the subsequent, in particular latch-based fixing of a pivoted circuit board section (3) to the light emitter (4) and/or of a pivoted circuit board section (3) to the light receiver (5) in the respective pivoted position.

## Revendications

1. Détecteur de fumée optique comportant une carte de circuits imprimés (2) présentant une épaisseur de carte de circuits imprimés uniforme (D) ainsi qu'un émetteur de lumière (4) et un récepteur de lumière (5), l'émetteur de lumière (4) et le récepteur de lumière (5) étant respectivement agencés sur une section (3) de la carte de circuits imprimés (2) et la section de carte de circuits imprimés respective (3) pouvant pivoter pour passer d'une position plane dans un plan commun avec la carte de circuits imprimés (2) dans une position de pivotement prévue pour la détection de fumée optique, et pouvant être fixée, **caractérisé en ce que** :
- la position de pivotement présente un angle (σ) compris dans une plage allant de 30° à 90° ;
- au moins l'une des deux sections de carte de circuits imprimés (3) est formée, respectivement à l'exception d'au moins une traverse restante (ST), par au moins un évidement continu (S) dans la carte de circuits imprimés (2) et
- la traverse respective (ST) présente une longueur de traverse (L) telle qu'un couple de flexion et/ou de torsion appliqué à la traverse respective (ST) dans la position de pivotement déforme élastiquement la traverse respective (ST).

2. Détecteur de fumée optique selon la revendication 1, la traverse respective (ST) présentant l'épaisseur de carte de circuits imprimés uniforme (D) et une largeur de traverse (B) sensiblement uniforme, et plus particulièrement comprise dans une plage de 0,5 mm à 3 mm.

3. Détecteur de fumée optique selon la revendication 1 ou 2, la traverse respective (ST) présentant une longueur de traverse (L) telle qu'un couple de flexion / de torsion appliqué à la traverse respective (ST) dans la position de pivotement diminue le long de la dimension longitudinale de la traverse respective (ST).

4. Détecteur de fumée optique selon la revendication 3, la carte de circuits imprimés (2) étant réalisée en un matériau de base, et plus particulièrement en un matériau de base FR4 ou FR2, et la longueur de traverse respective (L) étant en outre telle qu'une valeur de la résistance à la flexion, maximale autorisée et spécifiée pour le matériau de base, n'est pas dépassée.

5. Détecteur de fumée optique selon l'une des revendications précédentes, la traverse respective (ST) étant formée en forme de méandres ou en forme de barre en tant que barre de torsion.

6. Détecteur de fumée optique selon l'une des revendications précédentes, le détecteur de fumée comportant une unité de commande et d'évaluation (MC) agencée sur la carte de circuits imprimés (2), sur une première des deux sections (3) des émetteurs de lumière (4) étant agencés un élément de commutation commandable (7) et un accumulateur d'énergie électrique (8), entre la première section (3) et l'unité de commande et d'évaluation (MC) passant au moins deux pistes conductrices via l'au moins une traverse (ST) le long de la dimension longitudinale de celle-ci et les au moins deux pistes conductrices étant prévues pour l'alimentation électrique tampon et la commande par impulsions électriques de l'émetteur de lumières (4) par l'unité de commande et d'évaluation (MC).

7. Détecteur de fumée optique selon l'une des revendications précédentes, le détecteur de fumée comportant une unité de commande et d'évaluation (MC) agencée sur la carte de circuits imprimés (2), sur une deuxième des deux sections (3) étant disposé le récepteur de lumière (5) ainsi qu'un amplificateur (9) qui y est relié, entre la deuxième section (3) et l'unité de commande et d'évaluation (MC) passant au moins deux pistes conductrices via l'au moins une traverse (ST) le long de la dimension longitudinale de celle-ci et les au moins deux pistes conductrices étant prévues pour l'alimentation en courant du récepteur de lumière (5) et de l'amplificateur (9) ainsi que pour la détection métrologique d'un photosignal, amplifié émis par l'amplificateur (9), par l'unité de commande et d'évaluation (MC) .

8. Détecteur de fumée optique selon l'une des revendications précédentes, la traverse respective (ST) étant, dans la position de pivotement fixée, pourvue d'une masse de scellement durcissable pour le délestage mécanique au moins partiel de la traverse respective (ST).

9. Détecteur de fumée optique selon l'une des revendications précédentes, l'émetteur de lumière (4) et le récepteur de lumière (5) étant agencés sur la section respective (3) et orientés optiquement de telle sorte que l'émetteur de lumière (4) et le récepteur de lumière (5) sont, dans la position de pivotement fixée, agencés en un système de lumière diffusée ou en un système de lumière transmise.

10. Détecteur de fumée optique selon la revendication 9, la position de pivotement de l'au moins une section de carte de circuits imprimés (3) présentant un angle (σ) compris dans une plage allant de 30° à 60°, l'émetteur de lumière (4) et le récepteur de lumière (5) étant agencés en un système de lumière diffusée et orientés sur un volume de mesure commun (MV), le volume de mesure (MV) étant, par rapport à l'agencement de l'émetteur de lumière (4) et/ou du récepteur de lumière (5), sur un côté de montage (MS) de la carte de circuits imprimés (2) sur un côté opposé (GS) de la carte de circuits imprimés (2) et la carte de circuits imprimés (2) présentant une ouverture de passage (OF) respective, servant plus particulièrement de diaphragme (BL), pour limiter optiquement une plage de rayonnement de l'émetteur de lumière (4) et/ou pour limiter optiquement une plage de réception du récepteur de lumière (5).

11. Détecteur de fumée optique selon l'une des revendications précédentes, l'émetteur de lumière (4) et le récepteur de lumière (5) étant agencés en un système de lumière diffusée ou de lumière transmise, un volume de mesure (MV) pour la détection de la lumière diffusée ou de la lumière transmise étant situé vis-à-vis d'un côté de montage (MS) de la carte de circuits imprimés (2), le détecteur de fumée optique comportant un couvercle (AB) en direction du volume de mesure (MV) avec des structures absorbant la lumière et/ou réfléchissant la lumière, et le couvercle (AB) étant adjacent à ce côté de montage (MS).

12. Détecteur de fumée optique selon la revendication 11, le couvercle (AB) présentant des évidements (AU) pour l'émetteur de lumière (4) et/ou pour le récepteur de lumière (5).

13. Détecteur de fumée optique selon la revendication 12, les évidements (AU) étant en outre prévus pour limiter optiquement une plage de rayonnement de l'émetteur de lumière (4) et/ou pour limiter optiquement une plage de réception du récepteur de lumière (5) au sens d'un diaphragme (BL).

14. Détecteur de fumée optique selon l'une des revendications 11 à 13, le couvercle (AB) présentant, de manière adjacente à un évidement respectif (AU) pour l'émetteur de lumière (4) et/ou pour le récepteur de lumière (5), au moins un support (H) orienté de manière allant s'éloignant du côté de montage à couvrir (MS) de la carte de circuits imprimés (2) et le support respectif (H) étant prévu pour fixer dans la position de pivotement respective, au moyen de l'émetteur de lumière (4), une section traversante de la carte de circuits imprimés (3) ayant subi un pivotement et/ou, au moyen du récepteur de lumière (5), une section traversante de la carte de circuits imprimés (3) ayant subi un pivotement.

15. Détecteur de fumée optique selon l'une des revendications 11 à 13, le couvercle (AB) pour l'émetteur de lumière (4) et/ou pour le récepteur de lumière (5) présentant au moins un support (H) orienté en direction du côté de montage (MS) à recouvrir de la carte de circuits imprimés (2) et le support respectif (H) étant prévu pour faire pivoter et pour ensuite fixer, en particulier par engagement, dans la position de pivotement respective, au moyen de l'émetteur de lumière (4), une section de carte de circuits imprimés (3) ayant subi un pivotement et/ou, au moyen du récepteur de lumière (5), une section de carte de circuits imprimés (3) ayant subi un pivotement.
